# EUROPÄISCHE PATENTSCHRIFT

(11) **EP 1 405 208 B1**
(45) Veröffentlichungstag und Bekanntmachung des Hinweises auf die Patenterteilung: **15.08.2007**
(21) Anmeldenummer: 01911620.1
(22) Anmeldetag: 08.02.2001
(51) Int. Cl.: G06F 17/30, G06F 17/50

(54) **VERFAHREN, COMPUTERPROGRAMMPRODUKT SOWIE COMPUTERSYSTEM ZUM AUTOMATISCHEN ERSTELLEN EINER FILTEREINRICHTUNG**
METHOD, COMPUTER PROGRAM PRODUCT AND COMPUTER SYSTEM FOR THE AUTOMATIC PRODUCTION OF A FILTER INSTALLATION
PROCEDE, PRODUIT PROGRAMME INFORMATIQUE ET SYSTEME INFORMATIQUE POUR LA CREATION AUTOMATIQUE D'UN DISPOSITIF DE FILTRAGE

(30) Priorität: 22.02.2000 DE 10008017
(43) Veröffentlichungstag der Anmeldung: 07.04.2004
(73) Patentinhaber: SARTORIUS AG, 37075 Göttingen (DE)
(72) Erfinder: KÖHLER, Ulrich, 37139 Adelebsen (DE); QUASCHNING, Ulrich, 37077 Göttingen (DE); VON DER HARDT, Jochen, 37073 Göttingen (DE)
(74) Vertreter: Müller-Boré & Partner Patentanwälte
(86) Internationale Anmeldenummer: PCT/EP2001/001361
(87) Internationale Veröffentlichungsnummer: WO 2001/063468

(56) Entgegenhaltungen:
- EP-A- 0 801 355
- EP-A- 0 869 450
- DE-A- 4 218 504
- US-A- 5 386 506
- YOO M S ET AL: "DEBBIE: a configurable user interface for CAD frameworks" PROCEEDINGS OF THE INTERNATIONAL CONFERENCE ON COMPUTER DESIGN: VLSI IN COMPUTERS AND PROCESSORS. CAMBRIDGE, MA., SEPT. 17 - 19, 1990, LOS ALAMITOS, IEE COMP. SOC. PRESS, US, 17. September 1990 (1990-09-17), Seiten 135-140, XP010020935 ISBN: 0-8186-2079-X
- ALDOUS K J: "A system for the automatic retrieval of information from a specialist database" INFORMATION PROCESSING & MANAGEMENT, ELSEVIER, BARKING, GB, Bd. 32, Nr. 2, 1. März 1996 (1996-03-01), Seiten 139-154, XP004001119 ISSN: 0306-4573
- WOLSKI A: "LINDA: a system for loosely integrated databases" DATA ENGINEERING, 1989. PROCEEDINGS. FIFTH INTERNATIONAL CONFERENCE ON LOS ANGELES, CA, USA 6-10 FEB. 1989, WASHINGTON, DC, USA,IEEE COMPUT. SOC. PR, US, 6. Februar 1989 (1989-02-06), Seiten 66-73, XP010015150 ISBN: 0-8186-1915-5

## Beschreibung

Die Vorliegende Erfindung betrifft ein Verfahren, ein Computerprogrammprodukt sowie ein Computersystem zum automatischen Erstellen einer aus einer Vielzahl von Bauteilen bzw. Elementen bestehenden Filtereinrichtung.

Es ist bekannt eine Filtereinrichtung aus einer Vielzahl von Bauteilen manuell zu erstellen. Hierbei werden die Daten gewöhnlicherweise von einem Außendienstmitarbeiter bei einem Kunden aufgenommen und über die Abteilung für technische Unterstützung an die Konstruktion weitergeleitet. In der Konstruktion wird überprüft, ob die Kundenwünsche realisierbar sind und gegebenenfalls muss eine Rücksprache mit diesem über die Abteilung für technische Unterstützung und den Außendienstmitarbeiter genommen werden. Die Erstellung der notwendigen Zeichnungen (z.B. Fertigungszeichnung und Maßblatt) benötigt in der Regel zwischen 2 bis 3 Wochen.

Das Dokument EP-A-0 869 450 offenbart ein Verfahren und System, mit dem in einfacher Weise eine Kühleinheit entworfen werden kann. Dabei werden Designdaten und/oder Designbedingungen der Kühleinheit durch Eingabe mit Hilfe eines ersten Eingabegerätes eingegeben. Die Designdaten und Designbedingungen können insbesondere Außenabmessungen, Dicke des Wärmeisolators, ein vorbestimmter Temperaturbereich, ein Kühl- oder Heizverlauf, eine Wärmelast und einen Anordnungsbereich für die Kühleinheit sein. Daraus werden die Kühleinheit charakterisierende Daten berechnet und über einen ersten Drucker ausgedruckt. Ein Benutzer des Entwurfsystems kann nur anhand der ausgedruckten charakteristischen Datenkomponenten des Kühlsystems z. B. den Kompressor, den Kondensator, den Verdampfer, einen Motor und einen Lüfter auswählen.

Aus der Druckschrift Yoo M. S. and Hru, Arding: "DEBBIE: A Configurable User Interface for CAD Frameworks", Proceeding of the international conference on computer design, Sept. 17-19, 1990, IEE Comp. Soc. Press, Seiten 135-140 ist eine Benutzerschnittstelle als Brücke zwischen einem CAD-System und dem Benutzer dargestellt. Es wird eine Fehlermeldung generiert, wenn eine von dem Benutzer eingegebene Eingabe ein Element bezeichnet, das sich nicht in der Datenbank befindet. D. h. der Benutzer kann eine Eingabe vornehmen, die als solche unzulässig ist, und wird erst nach der Eingabe darauf hingewiesen, dass ein der Eingabe zugeordnetes Element nicht verfügbar ist.

Es ist daher Aufgabe der vorliegenden Erfindung ein Verfahren, Computerprogramm und Computersystem vorzuschlagen, die ein zügiges Erstellen einer Filtereinrichtung ermöglichen.

Diese Aufgabe wird erfindungsgemäß durch ein Verfahren zum automatischen Erstellen einer aus einer Vielzahl von Bauteilen bzw. Elementen bestehenden Filtereinrichtung gemäß Anspruch 1, durch ein Computerprogrammprodukt gemäß Anspruch 8 und durch ein Computersystem gemäß Anspruch 9 gelöst. Bevorzugte Ausführungsformen der Erfindung sind Gegenstand der Unteransprüche. Baukastenelementen bestehenden Filtereinrichtung bereit, welches folgende Schritte aufweist:
Auswählen eines Anwendungsbereiches der zu erstellenden Filtereinrichtung unter einer Vielzahl von vorbestimmten bzw. vorbestimmbaren Anwendungsbereichen und/oder
Auswählen einer Ausführungsart der zu erstellenden Filtereinrichtung unter einer Vielzahl von vorbestimmten bzw. vorbestimmbaren Ausführungsarten;
Erstellen eines Eingabefeldes in Abhängigkeit der getroffenen Auswahl, wobei in dem Eingabefeld lediglich jene Eingaben ermöglicht werden, welche der getroffenen Auswahl entsprechen;
Überprüfen, ob die in jedem Eingabefeld vorgenommenen Eingaben miteinander kompatibel sind, und zwar durch Ab- bzw. Aufrufen von den Eingaben entsprechenden Datensätzen, weiche in einer Datenbank bzw. einem Datenspeicher-Bereich abgelegt sind,
wobei der Schritt des Überprüfens einen Schritt des automatischen Generierens einer Fehlermeldung aufweist, falls die in jedem Eingabefeld vorgenommenen Eingaben miteinander nicht kompatibel sind.

Die vorzunehmende ein- oder mehrstufige Auswahl ermöglicht somit eine vorteilhafte Filterung derjenigen Bauteile, die zu der Filtereinrichtung zusammengesetzt werden, so dass auch ein nicht geschulter Mitarbeiter, eine Filtereinrichtung automatisch bzw. automatisiert erstellen kann. Des weiteren wird durch die bevorzugte Einordnung der Bauteile in eine Datenstruktur, die ein Baukastensystem darstellt, bzw. deren Auswahl aus einem solchen Baukastensystem eine einfache technische Umsetzung bei der Erstellung eines Angebots sowie bei dessen Herstellung.

Gemäß einer bevorzugten Ausführungsform der vorliegenden Erfindung weist der Schritt des Erstellens einen Schritt des Ermittelns der Anzahl von Datensätzen auf, die der getroffenen Auswahl entsprechen.

Bevorzugt umfasst der Schritt des Erstellens einen Schritt des Erstellens von sequentiell abzuarbeitenden Eingabefeldern, wobei die sequentiell abzuarbeitenden Eingabefelder zumindest teilweise den jeweiligen Bauteilen der zu erstellenden Filtereinrichtung entsprechen.

Weiterhin bevorzugt, stehen in den sequentiell abzuarbeitenden Eingabefeldern lediglich diejenigen Bauteile zur Auswahl und können entsprechend eingegeben bzw. aufgerufen werden, die der getroffenen Auswahl entsprechen.

Daher können Eingabefehler sofort ermittelt werden und geeignet behoben werden. Bevorzugt werden bei der Behebung automatisch Vorschläge unterbreitet, wie die fehlerhafte Eingabe korrigiert werden kann.

Weiterhin bevorzugt sind die abgerufenen Datensätze technische Eigenschaften der Bauteile, die in den entsprechenden Eingabefeldern ausgewählt wurden, wobei die Eigenschaften bevorzugt eine oder mehrere Abmessungen der einzelnen Bauteile umfassen.

Dementsprechend wird der Benutzer auf die fehlerhafte Eingabe bzw. Auswahl von Bauteilen hingewiesen.

Gemäß einer weiteren bevorzugten Ausführungsform erfolgt die Auswahl der Ausführungsart der zu erstellenden Filtereinrichtung in Abhängigkeit von zumindest einem der folgenden Parameter: der Anzahl an Filtereinrichtungskammern, des gewünschten Volumens bzw. Volumenbereiches eines Gehäuses der Filtereinrichtung, der gewünschten Filtrationsrate bzw. -geschwindigkeit der Filtereinrichtung, eines eingesetzten Filtrationsmoduls bzw. Filterkerze, der Rohrinnendurchmesser einzelner Bauteile, einer Belüftungsart des Gehäuses.

Bevorzugt erfolgt die Auswahl des Anwendungsbereiches der zu erstellenden Filtereinrichtung in Abhängigkeit von zumindest einem der folgenden Parameter: einer Anwendung der Filtereinrichtung für einen pharmazeutischen Bereich, einer Anwendung der Filtereinrichtung für einen chemischen Bereich, einer Anwendung der Filtereinrichtung für die Filtrierung von Getränken, einer Anwendung der Filtereinrichtung zum Filtern von Gasen, einer Anwendung der Filtereinrichtung zum Filtern von Flüssigkeiten.

Am bevorzugtesten weist das Verfahren weiterhin einen Schritt des Erstellens einer Zeichnung auf einem Anzeigegerät bzw. auf einem lesbaren Medium in Abhängigkeit der ausgewählten bzw. eingegebenen Bauteile aufweist.

Die Erfindung stellt weiterhin ein Computerprogrammprodukt zum automatischen Erstellen einer aus einer Vielzahl von Bauteilen bzw. Elementen bestehenden Filtereinrichtung bereit, das direkt oder indirekt in den internen Speicher eines Computers geladen werden kann und Kodierungsabschnitte umfasst, die ein Verfahren zum automatischen Erstellen einer aus einer Vielzahl von Bauteilen bzw. Elementen bestehenden Filtereinrichtung gemäß der Erfindung oder einr Ausführungsform hiervon ausführen können.

Weiterhin stellt die Erfindung ein Computersystem zum automatischen Erstellen einer aus einer Vielzahl von Bauteilen bzw. Elementen bestehenden Filtereinrichtung bereit, welches eine Speichereinheit, eine Auswerteeinheit, eine Eingabeeinheit und eine Ausgabeeinheit umfasst, wobei die Eingabeeinheit Mittel zum Auswählen eines Anwendungsbereiches der zu erstellenden Filtereinrichtung unter einer Vielzahl von vorbestimmten bzw. vorbestimmbaren Anwendungsbereichen und/oder Mittel zum Auswählen einer Ausführungsart der zu erstellenden Filtereinrichtung unter einer Vielzahl von vorbestimmten bzw. vorbestimmbaren Ausführungsarten; wobei die Auswerteeinrichtung Mittel zum Erstellen eines Eingabefeldes auf der Anzeigeeinrichtung in Abhängigkeit der getroffenen Auswahl aufweist, wobei in dem Eingabefeld lediglich jene Eingaben ermöglicht werden, welche der getroffenen Auswahl entsprechen, wobei die Auswerteeinrichtung ferner Mittel zum Überprüfen aufweist zum Überprüfen, ob die in jedem Eingabefeld vorgenommenen Eingaben miteinander kompatibel sind, und zwar durch Ab- bzw. Aufrufen von den Eingaben entsprechenden Datensätzen, welche in einer Datenbank bzw. einem Datenspeicher-Bereich abgelegt sind, und wobei die Auswerteeinrichtung ferner Mittel zum automatischen Generieren einer Fehlermeldung aufweist, falls die in jedem Eingabefeld vorgenommenen Eingaben miteinander nicht kompatibel sind.

Weitere Aufgaben, Vorteile und Merkmale der vorliegenden Erfindung sind aus der nachfolgenden beispielhaften Beschreibung bevorzugter Ausführungsformen mit Bezug auf die Zeichnung ersichtlich, in der:
FIG. 1 ein Flussdiagramm ist, in dem der Programmstart bzw. Ladevorgang des Programms gemäß einer bevorzugten Ausführungsform der Erfindung dargestellt ist;
FIG. 2 ein Flussdiagramm ist, in dem der Verfahrens- bzw. (Unter-) Programmablauf bei einem Anlegen eines neuen Projektes gemäß einer bevorzugten Ausführungsform der Erfindung dargestellt ist;
FIG. 3 ein Flussdiagramm ist, das den Verfahrens- bzw. (Unter-) Programmablauf gemäß einer bevorzugten Ausführungsform darstellt, nach dem ein Formular erstellt worden ist;
FIG. 4 ein Flussdiagramm ist, das den Verfahrens- bzw. (Unter-) Programmablauf gemäß einer bevorzugten Ausführungsform darstellt, nach dem ein vorbestimmter bzw. vorbestimmbarer Eintrag (SSTab) aus einer Tabelle ausgewählt wird;
FIG. 5 ein Flussdiagramm ist, das den Verfahrens- bzw. (Unter-) Programmablauf gemäß einer bevorzugten Ausführungsform darstellt, nach dem eine weitere Überprüfung der im Eingabe-Formular eingegebenen bzw. ermittelten Daten;
FIG. 6 ein Flussdiagramm ist, das den Verfahrens- bzw. (Unter-) Programmablauf gemäß einer bevorzugten Ausführungsform darstellt, nach dem ein Befehl eingegeben wurde, eine Zeichnung der ermittelten Filtereinrichtung zu erstellen;
FIG. 7 ein Flussdiagramm ist, das den Verfahrens- bzw. (Unter-) Programmablauf gemäß einer bevorzugten Ausführungsform darstellt, nach dem ein Befehl eingegeben wurde, eine Zeichnung zu speichern;
FIG. 8 ein Beispiel einer graphischen Darstellung eines Eingabeformulars zum Eingeben bzw. Bestimmen der einzelnen Bauteile der Filtereinrichtung ist;
FIG. 9 ein Beispiel einer Fehlermeldung des in FIG. 5 dargestellten Verfahrens- bzw. (Unter-) Programmablaufes ist;
FIG. 10 eine Bauteile-Datenbank-Struktur zur Verwendung mit einer bevorzugten Ausführungsform der Erfindung darstellt;
FIG. 11 eine Zuordnungsdatenbank zur Verwendung mit einer bevorzugten Ausführungsform der Erfindung darstellt;
FIG. 12 ein Beispiel einer Filtereinrichtung für flüssige Medien zeigt, welches mehrere Bauteile aus einem Baukastensystem aufweist; und
FIG. 13 ein weiteres Beispiel einer Filtereinrichtung zeigt, die für ein gasförmiges Medium geeignet ist.

Gemäß einer bevorzugten Ausführungsform der Erfindung wird ein Computerprogrammprodukt sowie ein Verfahren bereitgestellt, dass die Zusammenstellung einer mehrere Teile bzw. Elemente bzw. Bauteile aufweisende Filtereinrichtung, insbesondere -gehäuse ermöglicht.

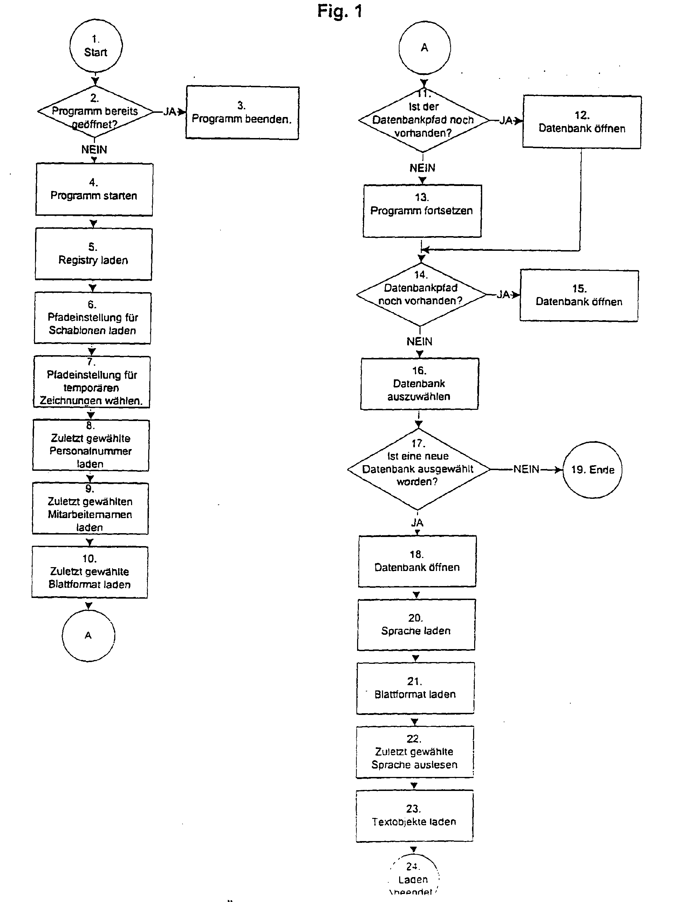

In FIG. 1 ist ein Programmstart bzw. Ladevorgang des Programms, d.h. die beim Anwählen des Programms und im unmittelbaren Anschluss durchgeführten Schritte, gemäß einer bevorzugten Ausführungsform der Erfindung dargestellt. Mit Schritt 1. ist der Programmstart bezeichnet. In Schritt 2. wird ermittelt, ob schon eine Instanz des Programms auf dem Rechner läuft. Ist dies der Fall (JA in Schritt 2.), so wird in Schritt 3. das neu gestartete Programm beendet. Ist hingegen keine Instanz auf dem Rechner initiiert (NEIN in Schritt 2.), so wird in Schritt 4. das sogenannte "Splash-Formular" geöffnet, indem ein Logo, die aktuelle Zeit, das aktuelle Datum, die Versionsnummer des Programms und/oder später die gewählte Benutzerdaten, wie z.B. die Personalnummer und der gewählte Mitarbeitername, zu sehen sind.

In Schritt 5. wird der Pfad für Vorschau-Bilder aus einer Registry bzw. einem Datenspeicher-Bereich geladen bzw. gelesen bzw. abgerufen. Wenn ein solcher Pfad nicht vorhanden ist, wird eine vorbestimmte bzw. vorbestimmbare Voreinstellung (z.B. "c:\programme\sartorius\vorschau\") gewählt bzw. eingelesen.

In Schritt 6. wird der Pfad für eine oder mehrere Anzeigen (sog. "Schablonen") aus der Registry bzw. einem Datenspeicher-Bereich geladen. Wenn ein solcher Pfad nicht vorhanden ist, wird eine vorbestimmte bzw. vorbestimmbare Voreinstellung (z.B. "c:\programme\sartorius\vorlagen und schabionen\") gewählt.

In Schritt 7. wird der Pfad für temporäre Zeichnungen aus der Registry bzw. einem Datenspeicher-Bereich geladen. Wenn nicht vorhanden, wird eine vorbestimmte bzw. vorbestimmbare Voreinstellung (z.B. "c:\windows\temp\") gewählt.

In Schritten 8. und 9. werden ein oder mehrere zuletzt eingegebene bzw. gewählte Benutzerdaten aus der Registry bzw. einem Datenspeicher-Bereich geladen, z.B. in Schritt 8. die zuletzt gewählte Personalnummer bzw. in Schritt 9. den zuletzt gewählten Mitarbeiternamen. Wenn keine Benutzerdaten vorhanden sind, wird in dem entsprechenden Schritt bzw. Unterschritt ein Leerstring geladen.

In Schritt 10. werden ein oder mehrere zuletzt gewählte Formatdaten aus der Registry bzw. einem Datenspeicher-Bereich geladen. Ist kein Datensatz verfügbar, so kann ein vorbestimmter bzw. vorbestimmbarer Formdaten-Satz (z.B. "DIN A4") aus der Registry bzw. einem Datenspeicher-Bereich geladen werden.

In Schritt 11. findet ein Zugriff auf eine Projekte-Datenbank (z.B. "Projekte.sag") bzw. einen Projekte-Datenspeicher-Bereich statt, in der vorangehend erstellte bzw. bearbeitete Projekte und entsprechende Verweise und/oder Projekt-bezogene Daten gespeichert bzw. abgelegt sind. In diesem Schritt wird insbesondere abgefragt bzw. untersucht, ob die entsprechende Projekte-Datenbank bzw. der entsprechende Projekte-Datenspeicher-Bereich, insbesondere "Projekte.sag" unter dem, in der Registry gespeicherten Pfad bzw. Verweis vorhanden ist. Ist ein gespeicherter Pfad bzw. Verweis vorhanden (JA in Schritt 11.), so wird in Schritt 12. die entsprechende Projekte-Datenbank, insbesondere "Projekte.sag" geöffnet bzw. die entsprechenden Daten gelesen. Ist hingegen kein gespeicherter Pfad bzw. Verweis vorhanden (NEIN in Schritt 11.), so wird in Schritt 13. das Programm fortgesetzt, wobei die Projekte-Datenbank bevorzugt später ausgewählt werden kann. Bevorzugt wird in Schritt 13. das Hauptformular (MDI) maximiert geöffnet.

Weiterhin wird in Schritt 14. abgefragt bzw. untersucht, ob eine weitere Datenbank (z.B. "Sartorius.sag") bzw. ein Datenspeicher-Bereich unter dem, in der Registry gespeicherten Pfad vorhanden bzw. verfügbar ist. Ist die Abfrage in Schritt 14. positiv, so wird in Schritt 15. die entsprechende weitere Datenbank (z.B. "Sartorius.sag") geöffnet bzw. der entsprechende Datenspeicher-Bereich ausgelesen. Ist hingegen die Abfrage in Schritt 14. negativ, so wird in Schritt 16. eine Aufforderung gestartet, eine neue Datenbank, insbesondere "Sartorius.sag" bzw. einen neuen Datenspeicher-Bereich auszuwählen. In dieser neuen Datenbank, insbesondere in "Sartorius.sag" bzw. in dem neuen Datenspeicher-Bereich sind diejenigen Daten abgespeichert, die notwendig sind, um das Programm mit allen Datenbank-Informationen für die Datenspeicher-Bereiche zu versorgen bzw. laden.

In Schritt 17. wird überprüft, ob eine neue Datenbank, z.B. "Sartorius.sag" bzw. ein neuer Datenspeicher-Bereich ausgewählt worden ist. Falls eine neue Datenbank, z.B. "Sartorius.sag" bzw. ein neuer Datenspeicher-Bereich ausgewählt worden ist (JA in Schritt 17.), wird diese Datenbank in Schritt 18. geöffnet bzw. der entsprechende Datenspeicher-Bereich ausgelesen. Falls hingegen keine neue Datenbank, z.B. "Sartorius.sag" bzw. kein neuer Datenspeicher-Bereich ausgewählt worden ist (NEIN in Schritt 17.), so wird in Schritt 19. das Programm beendet, da das Programm ohne die in der Datenbank bzw. im Datenspeicher-Bereich gespeicherten Daten nicht laufen kann.

In Schritt 20. werden Objekte vom Typ "Sprache" in einen Datenspeicher-Bereich "Sprachen" geladen, wobei das Objekt "Sprache" bevorzugt nur die Eigenschaft "Sprachenname" (z.B.: "deutsch") aufweist. Die Objekte werden aus einer nachfolgend näher zu beschreibenden Tabelle "Allgemein: Übersetzung" geladen. Jedes Objekt enthält den Namen einer Spalte der Tabelle.

In Schritt 21. werden ein oder mehrere Objekte vom Typ "Format" in einen Datenspeicher-Bereich "Formate" geladen, wobei das Objekt "Format" bevorzugt nur die Eigenschaft "Formatname" (z.B.: "DIN A4") aufweist. Die Objekte "Format" werden aus der nachfolgend näher zu beschreibenden Tabelle "Allgemein: Blattformate" geladen. Jedes Objekt enthält einen Eintrag der ersten Spalte der Tabelle.

In Schritt 22. wird die zuletzt für die Programmoberfläche gewählte Sprache aus der Registry bzw. Datenspeicher-Bereich ausgelesen, wobei, falls kein Eintrag vorhanden ist, eine vorbestimmte bzw. vorbestimmbare Sprache (z.B. "Deutsch") gewählt wird. Die ausgewählte Sprache wird bevorzugt in der Registry bzw. dem entsprechenden Datenspeicher-Bereich gespeichert. Falls in Schritt 22. die Sprache geändert wird von der vorangehend abgespeicherten Sprache, so wird in diesem Schritt ein Event ausgelöst, welches von jedem Formular empfangen wird, um dort sofort die Sprache von darin enthaltenen Informationen anzupassen. Alternativ oder zusätzlich kann auch ein entsprechendes Sprachen-Flag gesetzt werden.

In Schritt 23. werden Objekte vom Typ "Text" in einen Datenspeicher-Bereich "Texte" geladen, wobei das Objekt "Text" bevorzugt nur die Eigenschaft "Text" aufweist. Die Objekte werden bevorzugt aus der Tabelle "Allgemein: Übersetzung" geladen. Jedes Objekt enthält einen Eintrag der zweiten Spalte der Tabelle. Es wird unter einem Schlüssel gespeichert, der dem Wert in der ersten Spalte der Tabelle entspricht.

In Schritt 24. ist der Ladevorgang des Programms beendet.

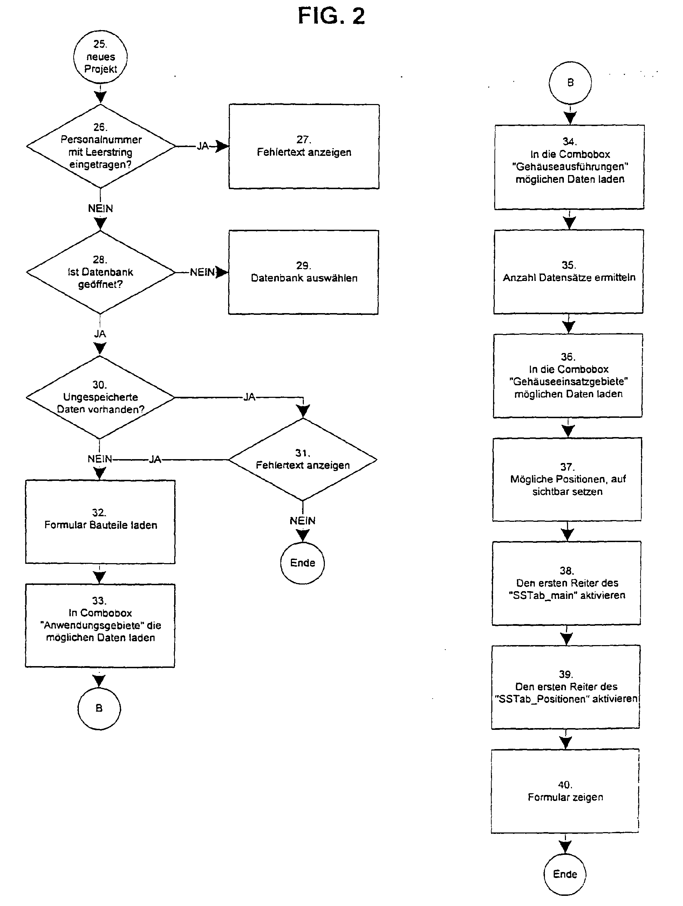

Wird nunmehr bei gestarteten Programm ein Menüpunkt "neues Projekt" ausgewählt als Befehl zur automatischen Erzeugung bzw. Erstellung einer Filtereinrichtung, so werden gemäß einer bevorzugten Ausführungsform der Erfindung folgende Schritte durchlaufen (FIG. 2).

In Schritt 25. wird der Befehl "neues Projekt" ausgelesen bzw. abgewartet. Wurde dieser Befehl erhalten, z.B. durch Auswahl in einem entsprechenden Pulldown-Menu so wird in Schritt 26. geprüft, ob unter den Benutzerdaten (z.B. der Personalnummer) ein Leerstring eingetragen ist oder ob der eingegebene String nicht eine vorbestimmte bzw. vorbestimmbare Mindestlänge (z.B. 4 Zeichen) aufweist. Ist das Ergebnis dieser Diskriminierung positiv (JA in Schritt 26.), so wird eine Fehlermeldung in Schritt 27. automatisch ausgegeben, z.B. eine Messagebox mit einem entsprechenden Fehlertext angezeigt. Nach Bestätigung der Fehlermeldung (z.B. wenn ein OK-Button geklickt wurde) wird ein entsprechendes Formular geöffnet, wo die Benutzerdaten, z.B. die Personalnummer, eingegeben werden kann. Wenn in Schritt 26. das Ergebnis NEIN ist, dann wird in Schritt 28. geprüft, ob die Projekte-Datenbank (z.B. "Projekte.sag") geöffnet ist bzw. ein entsprechender Projekte-Datenspeicher-Bereich verfügbar ist bzw. gelesen wurde. Falls das Ergebnis in Schritt 28. NEIN ist, so wird eine Aufforderung initiiert, eine Projekte-Datenbank (z.B. "Projekte.sag") auszuwählen. Wird keine Projekte-Datenbank, ausgewählt, wird die Aufforderungsprozedur verlassen, d.h. keine Projekte-Datenbank eingelesen. Wenn hingegen in Schritt 28. festgestellt wird, dass eine Projekte-Datenbank geöffnet ist (JA in Schritt 28.), so wird in Schritt 30. überprüft, ob noch nicht gespeicherte Daten geladen sind. Falls dies der Fall ist (JA in Schritt 30.), so wird in Schritt 31. eine entsprechende Fehlermeldung automatisch ausgegeben, z.B. eine entsprechende Messagebox mit passendem Fehlertext (z.B. "nicht gespeicherte Daten löschen") angezeigt und bevorzugt eine Eingabe-Aufforderung gestartet (z.B. JA/NEIN), wobei wenn z.B. "NEIN" geklickt wird, wird das Programm beendet; wird hingegen in Schritt 31. "JA" geklickt, so geht das Programm über zu Schritt 32.

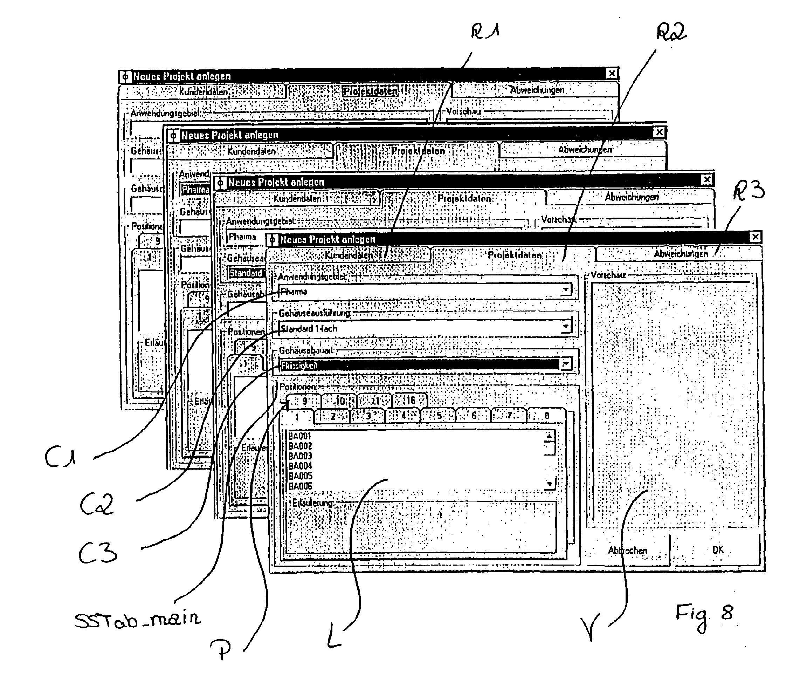

Wenn in der Diskriminierung in Schritt 30. festgestellt wird, dass keine ungespeicherten Daten vorhanden sind (NEIN in Schritt 30.), so wird in Schritt 32. ein Elemente- bzw. Bauteile-Formular geladen bzw. angezeigt, über das die Daten von Bauteilen der Filtereinrichtung eingegeben bzw. bestimmt werden können. Dieses Bauteile-Formular enthält bevorzugt zwei SSTab-Steuerelemente (Reiter). Das erste "SSTab_main" (z.B. 3 Reiter) ermöglicht (siehe FIG. 8) auf dem ersten Reiter R1 die Eingabe z.B. von kundenspezifischen Daten, auf dem zweiten Reiter R2 die Eingabe z.B. der projektspezifischen Daten mit Hilfe des zweiten SSTab-Steuerelements "SSTab_Positionen" und auf dem dritten Reiter R3 des SSTab-Steuerelements "SSTab_main" die Eingabe z.B. von eventuellen projektspezifischen Abweichungen und projektspezifischen Bemerkungen. Es können jedoch auch weniger oder mehr Reiter vorgesehen sein, je nach Anforderungen an die Filtereinrichtung.

In Schritt 33. werden in die Combobox C1 (z.B. "Anwendungsgebiete") die zur Auswahl stehenden bzw. möglichen Daten geladen, wobei diese je nach der in Schritt 22. ausgewählten Sprache noch übersetzt wird durch Laden der entsprechend abgespeicherten Daten bzw. in der ausgewählten Sprache angezeigt werden. Die in der Combobox C1 anzuzeigenden bzw. angezeigten Daten werden aus der Tabelle "Allgemein: Anwendungsgebiete" geladen. Sie enthalten die Einträge der Spalte "Anwendungsgebiete" der entsprechenden Tabelle. Die Combobox C1 ermöglicht somit dem Benutzer eine Auswahl z.B. der Anwendungsgebiete der zu erstellenden Filtereinrichtung (z.B. "Pharmabereich" für Filtereinrichtungen, die zum Einsatz in der pharmazeutischen Industrie bestimmt sind, oder "Getränke" für Filtereinrichtungen für die Getränkebranche).

In Schritt 34. werden in die Combobox C2 (z.B. "Gehäuseausführungen") die zur Auswahl stehenden bzw. möglichen Daten laden, wobei auch diese je nach ausgewählter Sprache übersetzt werden. Die in der Combobox C2 anzuzeigenden bzw. angezeigten Daten werden aus der Tabelle "Allgemein: Gehäuseausführungen" geladen. Sie enthalten alle Namen der Spalten der entsprechenden Tabelle. Somit ermöglicht die Combobox C2 dem Benutzer die Auswahl z.B. der Ausführungsart der Filtereinrichtung, z.B. ob die Filtereinrichtung ein oder mehrere Filtrationsmodule hat, kleine, mittlere oder große Filtrationsmodule hat und/oder ob die Gehäusebauart des Belüftungs-, Gas- und/oder Flüssig-Typs ist.

In Schritt 35. wird die Anzahl der Datensätze in der entsprechenden Tabelle ermittelt, wobei diese die Anzahl der möglichen Positionen P (FIG. 8) der zu erstellenden Filtereinrichtung darstellt.

In Schritt 36. werden in die Combobox C3 (z.B. "Gehäuseeinsatzgebiete") die möglichen Daten geladen, wobei auch diese je nach ausgewählter Sprache noch übersetzt werden bzw. in der ausgewählten Sprache angezeigt werden. Die in der Combobox C3 anzuzeigenden bzw. angezeigten Daten werden aus der Tabelle "Allgemein: Gehäuseeinsatzgebiet" geladen, wobei die Daten den Einträgen der Spalte "Gehäuse-Einsatzgebiet" der Tabelle entsprechen bzw. diese enthalten.

In Schritt 37. wird je nach der in Schritt 35. ermittelten Anzahl der möglichen Positionen P, die dementsprechenden Reiter des Steuerelements "SSTab_Positionen" auf sichtbar gesetzt (z.B. durch Markieren in Fettschrift der entsprechenden Positionsnummer auf den Reitern).

In Schritt 38. wird der erste Reiter des SSTab-Steuerelements "SSTab_main" aktiviert, und in Schritt 39. wird der erste Reiter des SSTab-Steuerelements "SSTab_Positionen" aktiviert.

In Schritt 40. wird das ermittelte bzw. erstellte Eingabe-Formular angezeigt bzw. zur Eingabe freigegeben.

Nach dem das Eingabe-Formular erstellt bzw. freigegeben worden ist, wird abgewartet, dass ein Eintrag in einem oder mehreren Feldern, insbesondere in den Comboboxen C1-C3 erfolgt.

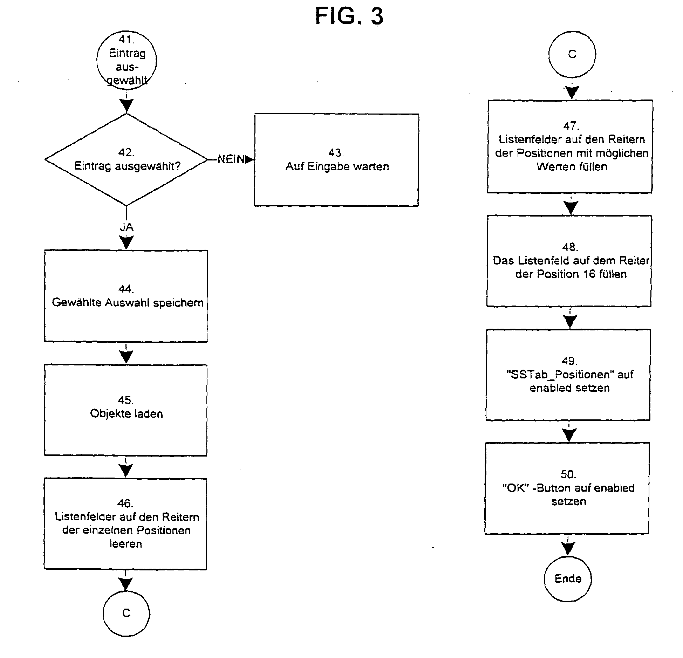

Wenn in Schritt 41. (FIG 3) eine Eingabe erfolgt ist, z.B. in einer der drei ComboBoxen C1-C3 ein Eintrag ausgewählt wird, wird sodann in Schritt 42. geprüft, ob die anderen Felder des Eingabe-Formulars ausgefüllt wurden, z.B. bei den anderen zwei ComboBoxen schon ein Eintrag ausgewählt wurde.

Falls in Schritt 42. ermittelt wird, dass noch Eingaben fehlen (NEIN in Schritt 42.), so wird auf eine oder mehrere entsprechende Eingaben gewartet. Falls hingegen in Schritt 42. das alle notwendigen Eingaben erfolgt sind (JA in Schritt 42.), werden in Schritt 44. die ausgewählten bzw. eingegebenen Daten (z.B. das gewählte Anwendungsgebiet, die gewählte Gehäuseausführung und die gewählte Gehäusebauart) gespeichert.

In Schritt 45. wird je nach der in der Combobox C2 gewählten bzw. bestimmten Gehäuseausführung die entsprechenden Objekte vom Typ "Tab" in die Sammlung "Tabs" geladen, wobei das Objekt "Tab" bevorzugt nur die Eigenschaft "Name" (z.B. eine produktspezifische Bezeichnung "BA-o") aufweist. Die entsprechenden Objekte werden aus der Tabelle "Allgemein: Gehäuseausführungen" geladen. Jedes Objekt enthält einen Eintrag der Spalte der gewählten Gehäuseausführung der Tabelle. Das ausgewählte Objekt wird bevorzugt unter dem Schlüssel gespeichert, der dem Wert in der Spalte "Position" der Tabelle entspricht.

In Schritt 46. werden die Listenfelder auf den Reitern der einzelnen Positionen P bevorzugt geleert, da eine Änderung der Einträge z.B. in den Combocoxen C1-C3, insbesondere eine Änderung der Kombination aus Anwendungsgebiet, Gehäuseausführung und Gehäusebauart, jederzeit möglich ist, d.h. nicht gesperrt ist.

In Schritt 47. werden die Listenfelder auf den Reitern der Positionen P mit möglichen Werten aus der Spalte "code" gefüllt und die Reiter auf enabled = true gesetzt, wo das unter der Positionsnummer zu findende Tab-Objekt unter der Eigenschaft "Name" keinen Leerstring enthält.

In Schritt 48. wird das Listenfeld auf dem Reiter der Position 16 (z.B. "Zertifikate") mit Werten der Spalte "code-" und "gewählte Sprache" aus der Tabelle "Allgemein: Zertifikate" gefüllt.

In Schritt 49. wird das SSTab-Steuerelement "SSTab_Positionen" auf enabled = true gesetzt. In Schritt 50. wird der "OK" -Button auf enabled = true gesetzt.

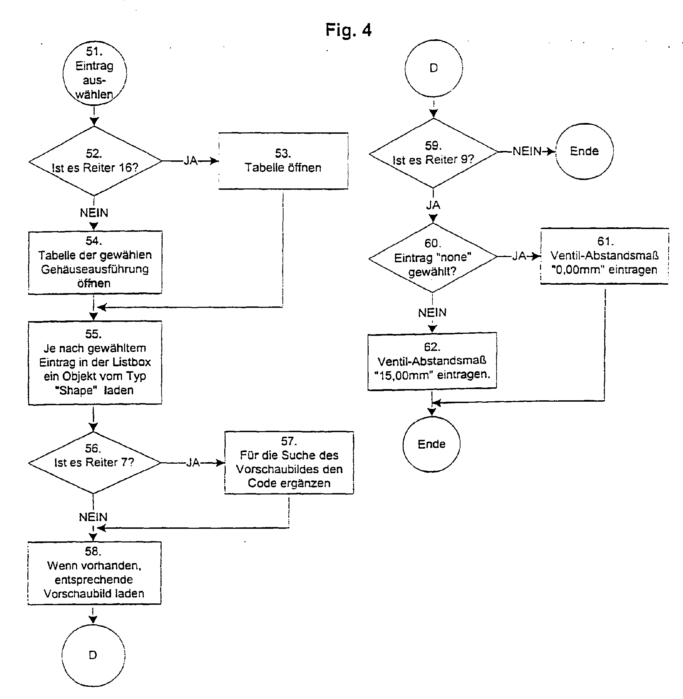

In Schritt 51. (FIG. 4) wird in einer Listbox auf einem SSTab-Steuerelement "SSTab_Positionen" ein Eintrag ausgewählt. In Schritt 52. wird überprüft, ob der entsprechend ausgewählte Reiter ein erster vorbestimmter bzw. vorbestimmbarer Reiter einer Reiterserie der Positionen P darstellt (z.B. Reiter 16 im Beispiel von FIG. 8). Falls der letzte Reiter der Reiterserie aus- bzw. angewählt wurde (JA in Schritt 52.), wird in Schritt 53. die Tabelle "Allgemein: Zertifikate" geöffnet und die unter dem gewählten Eintrag zu findende Beschreibung in der gewählten Sprache in das unter der Listbox zu findende Labelfeld geladen. Ist hingegen die Antwort in Schritt 52. NEIN, so wird in Schritt 54. die Tabelle der gewählten Gehäuseausführung geöffnet bzw. geladen und die unter dem gewählten Eintrag zu findende Beschreibung bevorzugt in der gewählten Sprache in das unter der Listbox zu findende Labelfeld L (FIG. 8) geladen.

In Schritt 55 wird je nach gewähltem Eintrag in der Listbox ein Objekt vom Typ "Shape" in eine Sammlung "Shapes" laden, wobei das Objekt vom Typ "Shape" bevorzugt folgende Eigenschaften aufweist: "Code", "Verkaufspreis", "Beschreibung", "Key", "Zeichnungs-Nr.", "Gezeichnet", "Rohrinnendurchmesser" und/oder "Nenninhalt". Die Objekte werden aus einer der oben geöffneten Tabelle geladen. Jedes Objekt wird unter dem Schlüssel gespeichert, der dem Wert der "Position" entspricht.

In Schritt 56. wird ermittelt bzw. überprüft, ob der Reiter einem zweiten vorbestimmten bzw. vorbestimmbaren Reiter der Reiterserie entspricht (z.B. Reiter 7). Falls dies der Fall ist (JA in Schritt 56.), so wird in Schritt 57. für die Suche des Vorschaubildes der entsprechende Vorschau-Code verändert bzw. markiert (z.B. um ein "u" ergänzt). Wenn hingegen der Reiter nicht dem zweiten vorbestimmten Reiter entspricht (NEIN in Schritt 56.) so wird in Schritt 58., wenn vorhanden, das dem code entsprechende Vorschaubild in das entsprechende Vorschaufeld V geladen.

In Schritt 59. wird weiterhin überprüft, ob der Reiter einem dritten vorbestimmten bzw. vorbestimmbaren Reiter entspricht (z.B. Reiter 9). Falls keine Entsprechung vorliegt (NEIN in Schritt 59.), dann ist dieser (Unter-) Programmablauf bzw. diese Subroutine abgeschlossen. Wenn hingegen der Reiter dem dritten Reiter entspricht (JA in Schritt 59.), so wird in Schritt 60. überprüft, ob der Eintrag "none" in der Listbox gewählt ist. Falls ja, dann wird in Schritt 61. ein vorbestimmtes bzw. vorbestimmbares erstes Ventilabstandsmaß (z.B. "0,00 mm" als Ventil-Abstandsmaß) eingetragen bzw. gespeichert und/oder angezeigt. Ist hingegen der Eintrag "none" nicht gewählt (NEIN in Schritt 60.), so wird in Schritt 62. ein zweites vorbestimmtes bzw. vorbestimmbares Ventilabstandsmaß (z.B. "15,00 mm" als Ventil-Abstandsmaß) eintragen bzw. gespeichert und/oder angezeigt.

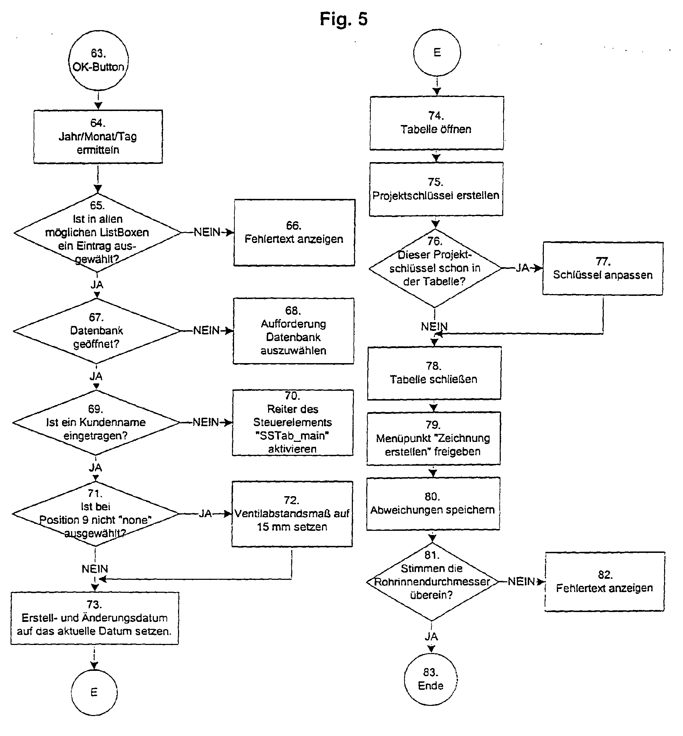

Nach Abschluss der in FIG. 5 gezeigten Routine wird abgewartet, dass eine Freigabe-Eingabe getätigt wird, z.B. durch Klicken eines "OK"-Buttons in dem Eingabeformular. Wird in Schritt 63. die Freigabe eingegeben (z.B. "OK"-Button wird geklickt), so wird in Schritt 64. ein Zeitstempel ermittelt (z.B. Jahr/Monat/Tag).

In Schritt 65. wird überprüft, ob in allen möglichen ListBoxen auf dem Steuerelement "SSTab_Positionen" bzw. in den entsprechenden Positionsfeldern des Formulars ein Eintrag ausgewählt ist. Falls dies nicht der Fall ist (NEIN in Schritt 65.), so wird eine entsprechende Fehlermeldung ausgegeben (z.B. wird Messagebox mit entsprechendem Fehlertext angezeigt). Dann wird bevorzugt abgewartet, dass die Fehlermeldung bestätigt wurde (z.B. durch Klicken eines "OK"-Buttons) und der entsprechende Reiter wird aktiviert, wobei die Subroutine bzw. Prozedur verlassen wird. Wurden alle Einträge getätigt (JA in Schritt 65.), so wird in Schritt 67. überprüft, ob eine Projekt-Datenbank (z.B. "Projekte.sag") geöffnet ist. Falls keine Projekt-Datenbank geöffnet ist (NEIN in Schritt 67.), so wird in Schritt 68. eine Aufforderung generiert, eine Projekt-Datenbank auszuwählen. Wird keine Projekt-Datenbank ausgewählt, wird die Prozedur bzw. Subroutine verlassen bzw. eine erneute Aufforderung generiert.

Falls eine Projekt-Datenbank geöffnet ist (JA in Schritt 67.), so wird in Schritt 69. überprüft, ob Kundenbezogene Daten (z.B. Kundenname, -adresse, -nummer usw.) eingetragen sind. Ist dies nicht der Fall (NEIN in Schritt 69.), so wird in Schritt 70. ein erster Reiter des Steuerelements "SSTab_main" aktiviert, wobei in dem Eingabeformular der Fokus auf das Eingabefeld für den Kundennamen gesetzt wird (z.B. durch Fettdruck, Schattieren, öffnen des entsprechenden Feldes oder dgl.) wobei die Prozedur bzw. Subroutine verlassen wird. Sind hingegen Kundenbezogene Daten eingegeben (JA in Schritt 69.), so wird in Schritt 71. überprüft, ob bei einer vorbestimmten Position P (z.B. Position 9) nicht "none" ausgewählt ist. Wenn ja, wird das Ventil-Abstandsmaß auf einen vorbestimmten bzw. vorbestimmbaren Wert (z.B. 15 mm) gesetzt. Ist in der vorbestimmten Position "none" ausgewählt (NEIN in Schritt 69.), so wird in Schritt 73. eine Datumsstempelung des Projekts vorgenommen, bevorzugt ein projektbezogenes Erstell- und Änderungsdatum auf das aktuelle Datum gesetzt.

In Schritt 74. wird sodann die Tabelle "Zeichnungen" in der Projekte-Datenbank geöffnet und in Schritt 75. ein Projektschlüssel erstellt. In Schritt 76. wird überprüft, ob es diesen Projektschlüssel schon in der Tabelle gibt. Falls dies der Fall ist (JA in Schritt 76.), so wird der Schlüssel entsprechend angepasst. Gibt es in der Tabelle den Projektschlüssel nicht in der Tabelle (NEIN in Schritt 76.), so wird in Schritt 78. die Tabelle "Zeichnungen" in der Projekt-Datenbank geschlossen.

In Schritt 79. wird dann in einem Eingabefeld ein Menüpunkt "Zeichnung erstellen" freigegeben. Die in das Formular bzw. in dessen entsprechenden Felder eingegebenen bzw. ausgewählten Werte werden erneuerbar gespeichert. insbesondere werden in Schritt 80. lediglich die abweichenden Werte gespeichert.

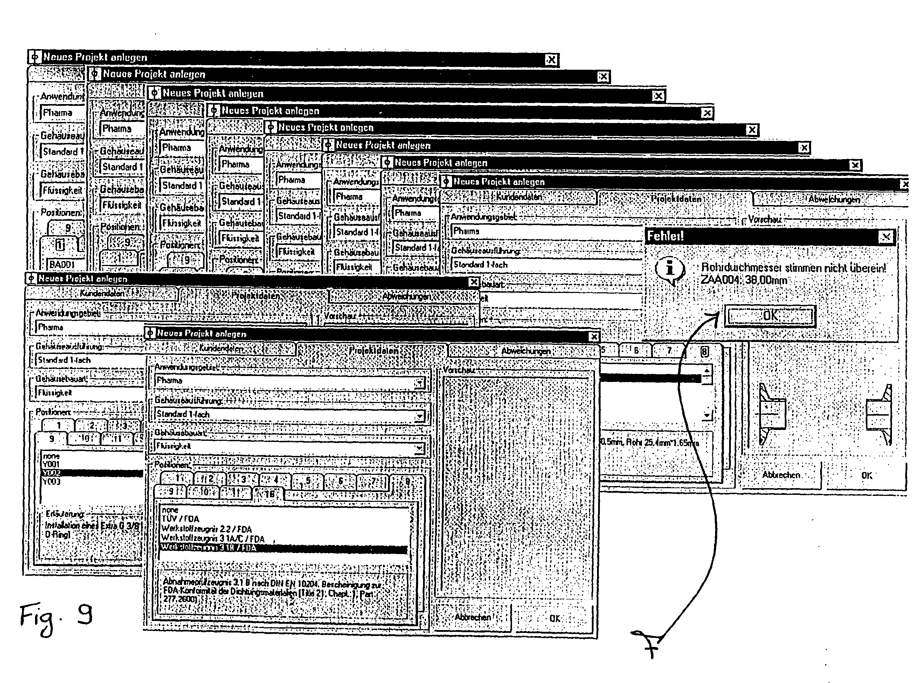

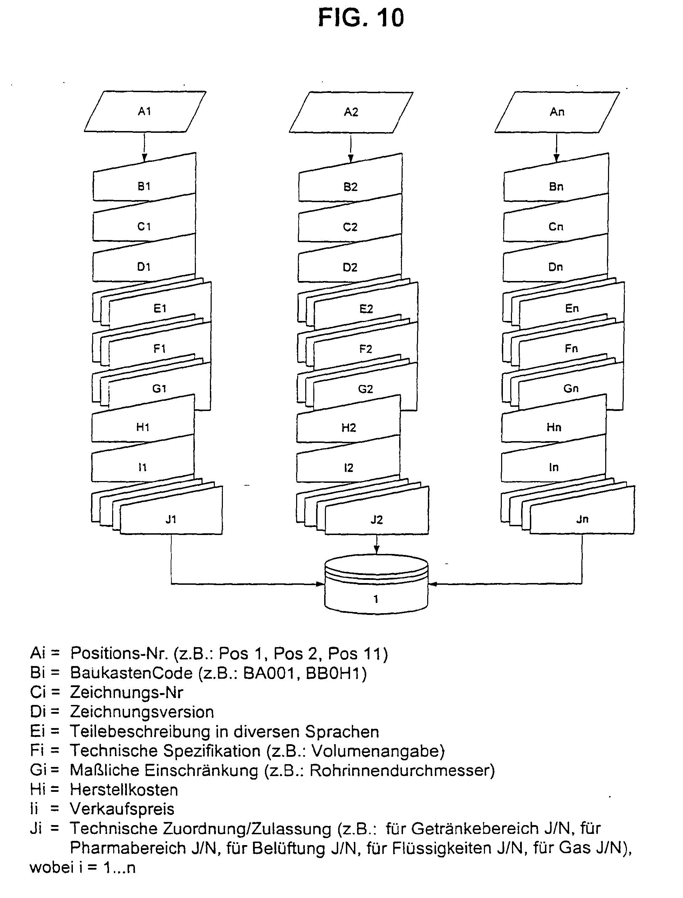

In Schritt 81. wird überprüft, ob die verschiedenen ausgewählten bzw. eingegebenen Elemente bzw. Bauteile der Filtereinrichtung aufeinander abgestimmt sind. Dies erfolgt durch Abfrage von vorbestimmten bzw. vorbestimmter Parameter der einzelnen Bauteile, welche in der Bauteile-Datenbank abgespeichert sind. So kann z.B. überprüft werden, ob die Rohrinnendurchmesser der einzelnen benachbarten Bauteile übereinstimmen, z.B. durch Abfrage der entsprechende Datenfelder F und/oder G innerhalb der Bauteile-Datenbank (FIG. 10). Diese Abfrage kann alternativ oder zusätzlich dadurch erfolgen, dass in eine Korrespondenztabelle aufgerufen wird, in der abgespeichert ist, welche Bauteile benachbart zu welchen weiteren Bauteilen angeordnet werden können. Stimmen die Parameter nicht überein und/oder ist die benachbarte Anordnung nicht möglich (NEIN in Schritt 81.), so wird eine entsprechende Fehlermeldung F (FIG. 9) generiert (z.B. wird eine Messagebox mit einem passenden Fehlertext anzeigt). Bevorzugt wird eine Bestätigung der Fehlermeldung abgefragt, wobei wenn diese Bestätigung vorgenommen wurde (z.B. wenn ein "OK"-Button geklickt wurde), wird zumindest ein Reiter aktiviert, der dem Bauteil entspricht, der mit seinem Nachbarn inkompatibel ist bzw. diesem nicht entspricht, und die Prozedur bzw. Subroutine wird verlassen.

Stimmen die Parameter überein und/oder ist die benachbarte Anordnung möglich (JA in Schritt 81.), so wird in Schritt 83. die Prozedur bzw. Subroutine beendet.

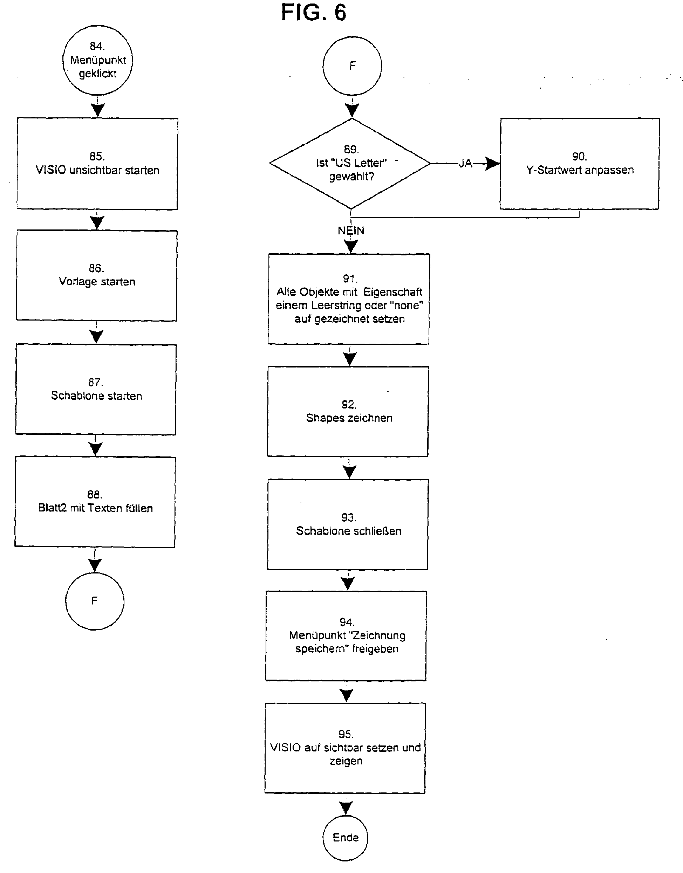

Nachfolgend wird ein Verfahrens- bzw. (Unter-) Programmablauf bzw. Subroutine mit bezug auf FIG. 6 beschrieben, wenn ein Befehl eingegeben wird, eine Zeichnung der aufgrund der Eingaben in das Formularfeld ermittelten Filtereinrichtung zu erstellen, z.B. durch Anklicken in Schritt 84. eines Menüpunkts "Zeichnung erstellen".

In Schritt 85. wird ein Zeichen- bzw. CAD-Programm (z.B. VISIO) bevorzugt versteckt gestartet. In Schritt 86. wird eine vorbestimmte bzw. vorbestimmbare Vorlage (Schablone), insbesondere durch Laden einer Default-Datei, gestartet. In Schritt 87. wird je nach der in dem entsprechende Feld gewählter Filtereinrichtungseigenschaften (z.B. aufgrund der in der Combobox C2 gewählten Gehäuseausführung) die dementsprechende Vorlage bzw. Schablone gestartet: Gegebenenfalls können in Schritt 88. auch Bauteile-Eigenschaften (z.B. Abmessungen, Angaben über Volumen und Durchsatz, usw.) in die Zeichnung aufgenommen werden, z.B. können in einem Blatt der Vorlage die Shapes mit Texten gefüllt werden (Schritt 88.). Falls ermittelt wird, dass der gewählte Formatdaten-Satz nicht der geladenen Schablone entspricht (z.B. durch die Abfrage "US Letter" gewählt? In Schritt 89.), werden die Daten der Schablone entsprechend angepasst (z.B. durch Anpassung des Y-Startwerts in Schritt 90.). Alternativ kann auch die dem ausgewählten Formatdaten-Satz entsprechende Schablone geladen werden.

Dann werden in Schritt 91. alle Objekte vom Typ "Shape", bei denen die Eigenschaft "code" entweder einen Leerstring oder das Wort "none" enthält auf gezeichnet = true gesetzt. Sodann werden in Schritt 92. die entsprechenden Shapes (Zeichnungselemente und/oder Text) gezeichnet und im Anschluss in Schritt 93. die Schablone geschlossen.

Im Anschluss wird in Schritt 94. ein Menüpunkt "Zeichnung speichern" freigeben, so dass nach entsprechender Bestätigung die Zeichnung gespeichert wird. In Schritt 95. wird dann das Zeichenprogramm, insbesondere VISIO auf sichtbar gesetzt und die erstellte Zeichnung gezeigt.

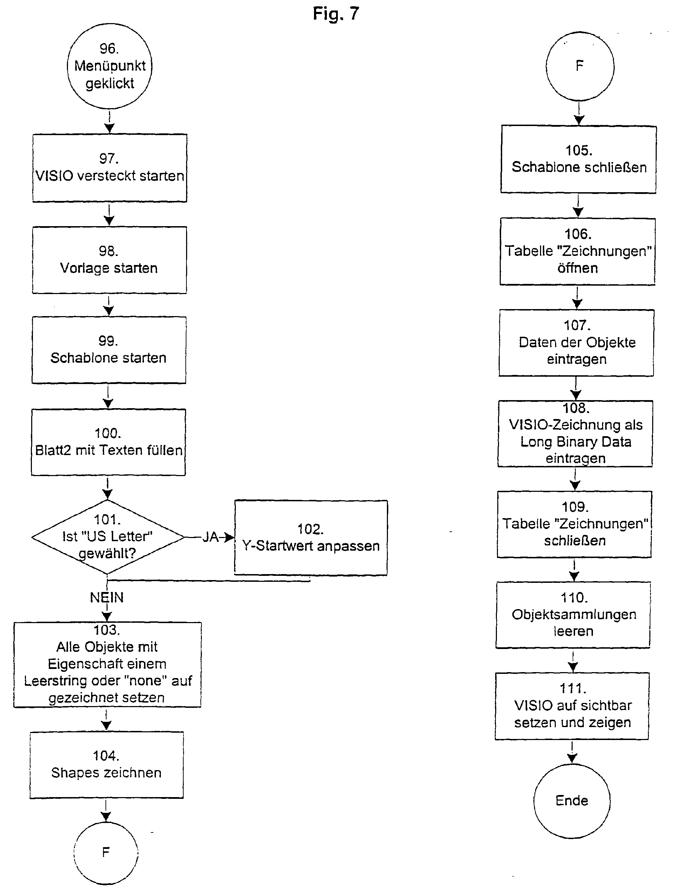

Wenn der Befehl "Zeichnung speichern" gegeben wird, so wird bevorzugt die in FIG. 7 dargestellte Subroutine bei Schritt 96. gestartet. Falls nicht schon erfolgt, wird das CAD- bzw. Zeichenprogramm (z.B. VISIO) in Schritt 97. bevorzugt versteckt gestartet. In Schritt 98. wird die gewählte Vorlage gestartet, wobei in Schritt 99 je nach Datenauswahl in dem Eingabe-Formular eine entsprechende Schablone gestartet wird (z.B. Starten der Schablone für die in der Combobox C2 gewählten Gehäuseausführung). Im Anschluss werden in den Schritten 100. bis 105. zu den Schritten 88. bis 93 ähnliche bzw. gleiche Programmabläufe durchlaufen, wobei bevorzugt noch eine Projekt-Nummer erstellt bzw. generiert und in die entsprechende Zeichnung eingefügt wird.

Bevorzugt werden in Schritt 100. in einen Teil der Vorlage die Shapes mit Texten gefüllt, in Schritt 101. geprüft, z.B. ob "US Letter" gewählt ist, falls JA in Schritt 102. ein Y-Startwert der Schablone angepasst. Im Anschluss werden in Schritt 103. alle Objekte vom Typ "Shape", bei denen die Eigenschaft "code" entweder einen Leerstring oder das Wort "none" enthält, auf gezeichnet = true gesetzt. Anschließend werden in Schritt 104. die Shapes in die Schablone gezeichnet und in Schritt 105. die offene Schablone geschlossen.

Dann wird in Schritt 106. die Tabelle "Zeichnungen" in der Projekt-Datenbank bzw. dem Datenspeicher-Bereich (z.B. die Datenbank "Projekte.sag") geöffnet. In Schritt 107. werden die Daten der Objekte in die Projekt-Datenbank eingetragen, wobei in Schritt 108. bevorzugt die VISIO-Zeichnung als Long Binary Data eingetragen wird. Anschließend wird in Schritt 109. die Tabelle "Zeichnungen" in der Projekt-Datenbank, insbesondere in "Projekte.sag", geschlossen. In Schritt 110. werden die Objektsammlungen geleert und in Schritt 111. wird das Zeichenprogramm (z.B. VISIO) auf sichtbar gesetzt und angezeigt.

In FIG. 10 ist eine Bauteile-Datenbank-Struktur zur Verwendung mit einer bevorzugten Ausführungsform der Erfindung. Die in FIG. 10 dargestellte Bauteile-Datenbank enthält n Datensätze, welche in den vorangehend beschriebenen Schritten abgefragt bzw. erneuert werden und den einzelnen Bauteilen entsprechen. Jeder Datensatz enthält bevorzugt ein Datenfeld Ai, welches einer Positions-Nummer (z.B.: Pos 1, Pos 2, Pos 11) entspricht, wobei die Positionsnummer abgefragt wird, um das entsprechende Bauteil in der entsprechenden Position des Eingabe-Formulars anzuzeigen.

Weiterhin umfasst jeder Bauteil-Datensatz ein oder mehrere von folgenden Datenfeldern (wobei i = 1...n):
- Datenfeld Bi, das einem Baukasten-Code des Bauteils entspricht (z.B.: BA001, BB0H1);
- Datenfeld Ci, das einer Zeichnungs-Nummer des entsprechenden Bauteils entspricht;
- Datenfeld Di, das einer Zeichnungsversion des Datenfeldes Ci entspricht;
- Datenfeld Ei , das einer Teilebeschreibung bevorzugt in unterschiedlichen Sprachen entspricht;
- Datenfeld Fi, das einen oder mehreren technischen Spezifikationen (z.B.: Volumenangabe, Durchflussrate, Filtrationsraten, Medium das filtriert werden kann, usw.) entspricht; dieses Datenfeld kann zur Diskriminierung verwendet werden, ob das Bauteil in einem Positionsfeld P in Abhängigkeit von der Auswahl des Anwendungsgebietes (Combobox C1) und/oder der Gehäuseausführung (Combobox C2) angezeigt bzw. als Auswahlmöglichkeit angegeben werden soll;
- Datenfeld Gi, das einer oder mehreren maßlichen und/oder bauartlichen Einschränkungen (z.B.: Rohrinnendurchmesser, Rohraussendurchmesser, Anschlussart, Volumen, Durchsatz usw.) entspricht; auch dieses Feld kann zur Diskriminierung verwendet werden, ob das Bauteil in einem Positionsfeld P in Abhängigkeit von der Auswahl des Anwendungsgebietes (Combobox C1) und/oder der Gehäuseausführung (Combobox C2) und/oder anderer Auswahlparameter (z.B. das Gesamtvolumen oder die Durchflussrate, die für die Filtereinrichtung gewünscht werden) angezeigt bzw. als Auswahlmöglichkeit angegeben werden soll;
- Datenfeld Hi, das den Herstellkosten des entsprechenden Bauteils entspricht;
- Datenfeld li, das dem Verkaufspreis entspricht;
- Datenfeld Ji, das einer technischen Zuordnung und/oder Zulassung des entsprechenden Bauteils (z.B.: für Getränkebereich J/N, für Pharmabereich J/N, für Belüftung J/N, für Flüssigkeiten J/N, für Gas J/N) entspricht. Das Datenfeld Ji kann auch als Tabelle "Allgemeine Anwendungsgebiete" verwendet werden.

Bei Auswahl des entsprechenden Bauteils können bevorzugt Datenfelder aufgerufen werden, welche bei der Anzeige ausgewertet werden, z.B. zum Ermitteln des Gesamtvolumens der Filtereinrichtung, der errechneten Filtrationsrate und/oder des Gesamtpreises oder Herstellungskosten der Filtereinrichtung.

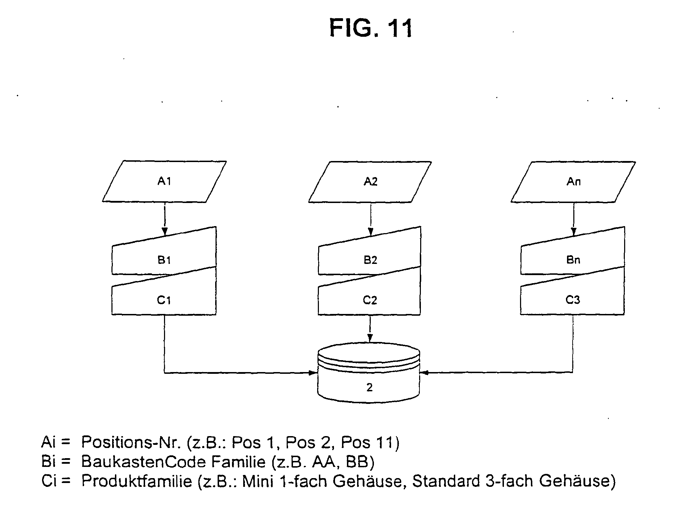

In FIG. 11 ist eine Zuordnungsdatenbank zur Verwendung mit einer bevorzugten Ausführungsform der Erfindung dargestellt, die eine Zuordnung von Bauteilen zu einer Produktfamilie entsprechend einer wählbaren bzw. gewählten Ausführungsart (Combibox C2) ermöglicht. Es ist daher eine "Vorauswahl" der anzuzeigenden Bauteilgruppen (z.B. AA..., BA...) nach Positionsnummer und/oder Produktfamilie möglich.

Die in FIG. 11 dargestellte Zuordnungs-Datenbank enthält n Datensätze, welche wie die Datensätze der Bauteile-Datenbank aus FIG. 10 in den vorangehend beschriebenen Schritten abgefragt bzw. erneuert werden und den einzelnen Bauteilen entsprechen. Jeder Datensatz der Zuordnungs-Datenbank enthält bevorzugt ein Datenfeld Ai, welches einer Positions-Nummer (z.B.: Pos 1, Pos 2, Pos 11) entspricht, wobei die Positionsnummer abgefragt wird, um das entsprechende Bauteil in der entsprechenden Position des Eingabe-Formulars anzuzeigen.

Weiterhin umfasst jeder Bauteil-Datensatz ein oder mehrere von folgenden Datenfeldern (wobei i = 1...n):
- Datenfeld Bi, das die Baukasten-Code-Familie (z.B. AA, BB) entspricht;
- Datenfeld Ci, das der Produktfamilie (z.B.: Mini 1-fach Gehäuse, Standard 3-fach Gehäuse) entspricht, und somit zur Diskriminierung bei der Anzeige der einzelnen Positionen nach erfolgter Gehäuseausführungsauswahl (Combobox C2) in den entsprechenden Positionsfeldern P dienen kann. Diese Produktfamilientabelle kann auch als "Allgemeine Gehäuse-Ausführungstabelle" verwendet werden.

Die Datenbanken sind bevorzugt als ACCESS-Datenbank gestaltet, jedoch kann auch jegliche andere Datenbankstruktur, sei sie relationeller oder nicht-relationeller Art, benutzt werden.

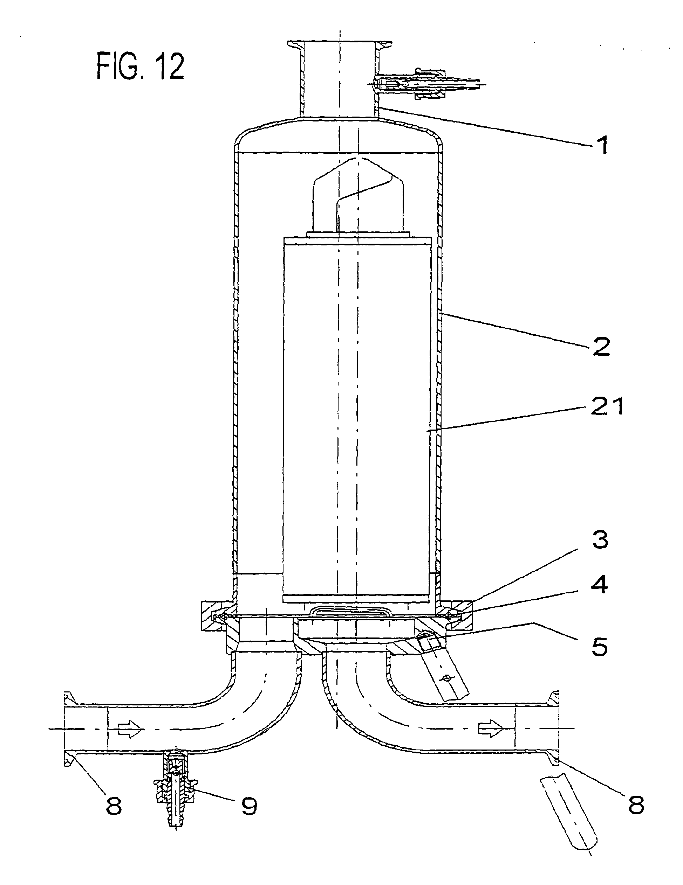

In FIG. 12 ist ein Beispiel einer Filtereinrichtung für flüssige Medien gezeigt, die aus verschiedenen Bauteilen bzw. Elementen aus einem Baukastensystem zusammengesetzt ist und die durch mittels einer bevorzugten Ausführungsform der Erfindung automatisch erstellt werden kann.

Die in FIG. 12 gezeigte Filtereinrichtung umfasst ein Oberteil 1 (entsprechend Position 1), welches z.B. geeignet ist, um an ein Druckmessgerät angeschlossen zu werden. Weiterhin ist das Oberteil bevorzugt mit einem seitlichen Ventil versehen zum Entlüften der Filtereinrichtung. Weiterhin ist ein Gehäusedorn 2 vorgesehen (entsprechend Position 2), welcher je nach Ausführung der Filtereinrichtung verschiedene Längen und Durchmesser aufweisen kann. Bevorzugt sind diese Parameter in dem System bzw. Verfahren bzw. Computerprogramm frei bzw. unter einer vorbestimmten oder vorbestimmbaren Auswahlmenge wählbar. Weiterhin umfasst die Filtereinrichtung zumindest einen Verschluss 3 (entsprechend Position 3), wobei diesbezüglich verschiedene Verschlüsse möglich sind, und eine Dichtung 4 (entsprechend Position 4), wobei für die Dichtung 4 verschiedene Materialien und/oder Formen möglich sind. Hiervon können insbesondere die Arten der Zertifizierung und/oder die Betriebsparameter der Filtereinrichtung (z.B. der Betriebsdruck) abhängen bzw. beeinflusst werden.

Die Filtereinrichtung ist weiterhin mit einer Bodenplatte 5 (entsprechend Position 5) versehen, welche mit verschiedenen Rohrabmessungen, Füße und/oder Ablassventile aufweisen kann. Bevorzugt sind die Ablassventile nur bei Filtereinrichtungen für Flüssigkeiten in die Bodenplatte integriert.

Weiterhin weist die Filtereinrichtung ein oder mehrere Anschlüsse 8 (entsprechend Position 8) für den Zu- und/oder Ablauf auf, welche von verschiedenen Anschlussarten (wie Clampverbindungen, Flanschverbindungen, usw.) sein können, wobei diese bevorzugt mit zusätzlich auswählbaren Anschlüssen 9 (entsprechend Position 9) versehen sein können, um weiteres Zubehör bzw. Extras anzuschließen.

Weiterhin umfasst die Filtereinrichtung eine Filterkerze bzw. ein Filtrationsmodul 21 (entsprechend Position 21), wobei je nach Ausführung der Filtereinrichtungen auch mehrere Filtrationsmodule 21 möglich sind.

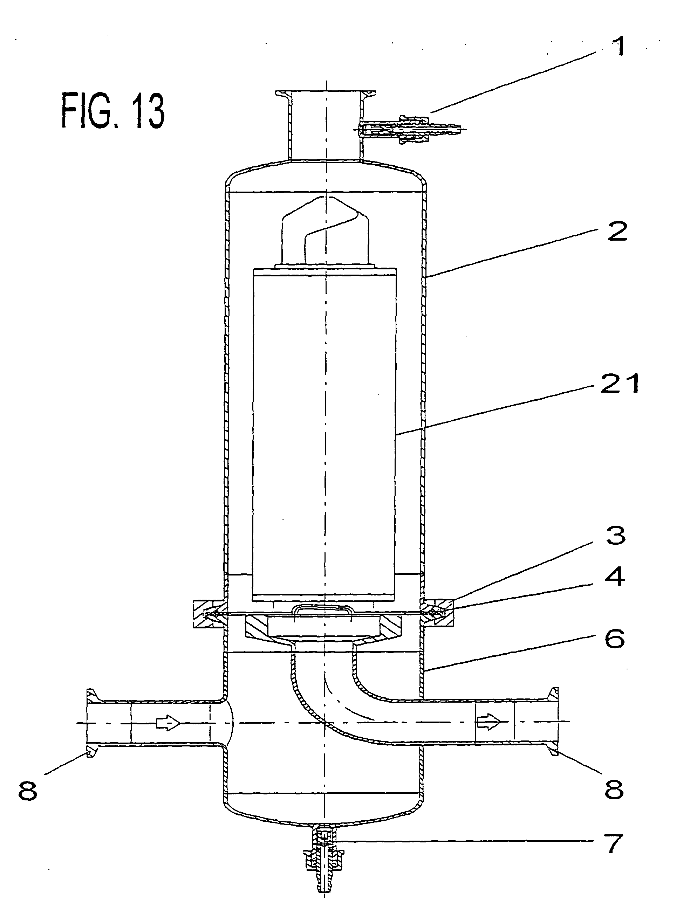

In FIG. 13 ist ein weiteres Beispiel einer Filtereinrichtung, die mittels der Erfindung automatisch erzeugt bzw. generiert bzw. zusammengestellt werden kann. Die in FIG. 13 gezeigte Filtereinrichtung wird für gasförmige Medien eingesetzt.

Teile bzw. Elemente bzw. Bauteile der in FIG. 12 dargestellten Filtereinrichtung, die gleich oder ähnlich jenen der in FIG. 11 dargestellten Filtereinrichtung sind, sind mit den gleichen Bezugszeichen gekennzeichnet und entsprechend den gleichen Positionsnummem wie jene der FIG. 11. Auf eine detaillierte Beschreibung wird daher verzichtet.

Die in FIG. 13 dargestellte Filtereinrichtung weist einen Kondensattopf 6 (entsprechend Position 6) auf, welcher verschiedene Rohrabmessungen aufweisen kann. Ein solcher Kondensattopf 6 wird bevorzugt lediglich bei Filtereinrichtungen für gasförmige Medien eingesetzt und entspricht somit einer unterschiedlichen Positionsnummer als die Bodenplatte 5 der Filtereinrichtung aus FIG. 12, weil die Bodenplatte 5 bevorzugt lediglich bei Filtereinrichtungen für flüssige Medien eingesetzt wird.

Weiterhin weist die Filtereinrichtung von FIG. 13 ein Unterteil 7 (entsprechend Position 7) auf, welches z.B. zum Entleeren des Kondensats dienen kann, welches sich in dem Kondensattopf 6 sammeln kann.

Obwohl in FIG. 13 keine Zusatzanschlüsse 9 zum Anschluss von Zubehör bzw. Extras dargestellt sind, können solche eventuell auch bei der Filtereinrichtung für gasförmige Medien vorgesehen werden.

## Patentansprüche

1. Verfahren zum automatischen Erstellen einer aus einer Vielzahl von Bauteilen bzw. Elementen bestehenden Filtereinrichtung, welches folgende Schritte aufweist:
Auswählen (Schritt 33.) eines Anwendungsbereiches (C1) der zu erstellenden Filtereinrichtung unter einer Vielzahl von vorbestimmten bzw. vorbestimmbaren Anwendungsbereichen und/oder
Auswählen (Schritt 34.) einer Ausführungsart (C2) der zu erstellenden Filtereinrichtung unter einer Vielzahl von vorbestimmten bzw. vorbestimmbaren Ausführungsarten;
Erstellen (Schritte 35.-40.) eines Eingabefeldes (P) in Abhängigkeit der getroffenen Auswahl, wobei in dem Eingabefeld (P) lediglich jene Eingaben ermöglicht werden, welche der getroffenen Auswahl (Schritt 33.; Schritt 34.) entsprechen;
Überprüfen (Schritt 81.), ob die in jedem Eingabefeld (P) vorgenommenen Eingaben miteinander kompatibel sind, und zwar durch Ab- bzw. Aufrufen von den Eingaben entsprechenden Datensätzen, welche in einer Datenbank bzw. einem Datenspeicher-Bereich abgelegt sind,
wobei der Schritt des Überprüfens (Schritt 81.) einen Schritt des automatischen Generierens (Schritt 82.) einer Fehlermeldung (F) aufweist, falls die in jedem Eingabefeld (P) vorgenommenen Eingaben miteinander nicht kompatibel sind.

2. Verfahren nach Anspruch 1, wobei der Schritt des Erstellens (Schritte 35.-40.) einen Schritt des Ermittelns (Schritt 35.) der Anzahl von Datensätzen aufweist, die der getroffenen Auswahl (Schritt 33.; Schritt 34.) entsprechen.

3. Verfahren nach einem der vorangehenden Ansprüche, wobei der Schritt des Erstellens (Schritte 35.-40.) einen Schritt des Erstellens von sequentiell abzuarbeitenden Eingabefeldern (P) umfasst, wobei die sequentiell abzuarbeitenden Eingabefelder (P) zumindest teilweise den jeweiligen Bauteilen der zu erstellenden Filtereinrichtung entsprechen.

4. Verfahren nach Anspruch 3, wobei in den sequentiell abzuarbeitenden Eingabefeldern (P) lediglich diejenigen Bauteile zur Auswahl stehen und entsprechend eingegeben werden können, die der getroffenen Auswahl (Schritt 33.; Schritt 34.) entsprechen.

5. Verfahren nach einem der vorangehenden Ansprüche, wobei die abgerufenen Datensätze technische Eigenschaften der Bauteile sind, die in den entsprechenden Eingabefeldern (P) ausgewählt wurden, wobei die Eigenschaften bevorzugt eine oder mehrere Abmessungen der einzelnen Bauteile umfassen.

6. Verfahren nach einem der vorangehenden Ansprüche, wobei die Auswahl (Schritt 34.) der Ausführungsart (C2) der zu erstellenden Filtereinrichtung in Abhängigkeit von zumindest einem der folgenden Parameter erfolgt: der Anzahl an Filtereinrichtungskammern, des gewünschten Volumens bzw. Volumenbereiches eines Gehäuses der Filtereinrichtung, der gewünschten Filtrationsrate bzw. -geschwindigkeit der Filtereinrichtung, eines eingesetzten Filtrationsmoduls, der Rohrinnendurchmesser einzelner Bauteile, einer Belüftungsart des Gehäuses.

7. Verfahren nach einem der vorangehenden Ansprüche, welches weiterhin einen Schritt (Schritte 74.-80.; Schritt 92) des Erstellens einer Zeichnung auf einem Anzeigegerät bzw. auf einem lesbaren Medium in Abhängigkeit der ausgewählten bzw. eingegebenen Bauteile aufweist.

8. Computerprogrammprodukt zum automatischen Erstellen einer aus einer Vielzahl von Bauteilen bzw. Elementen bestehenden Filtereinrichtung, das direkt oder indirekt in den internen Speicher eines Computers geladen werden kann und Kodierungsabschnitte umfasst, die ein Verfahren zum automatischen Erstellen einer aus einer Vielzahl von Bauteilen bzw. Elementen bestehenden Filtereinrichtung gemäß einem der vorangehenden Ansprüche ausführen können.

9. Computersystem zum automatischen Erstellen einer aus einer Vielzahl von Bauteilen bzw. Elementen bestehenden Filtereinrichtung, welches eine Speichereinheit, eine Auswerteeinheit, eine Eingabeeinheit und eine Ausgabeeinheit umfasst, wobei die Eingabeeinheit Mittel zum Auswählen (Schritt 33.) eines Anwendungsbereiches (C1) der zu erstellenden Filtereinrichtung unter einer Vielzahl von vorbestimmten bzw. vorbestimmbaren Anwendungsbereichen und/oder Mittel zum Auswählen (Schritt 34.) einer Ausführungsart (C2) der zu erstellenden Filtereinrichtung unter einer Vielzahl von vorbestimmten bzw. vorbestimmbaren Ausführungsarten; wobei die Auswerteeinrichtung Mittel zum Erstellen (Schritte 35.-40) eines Eingabefeldes (P) auf der Anzeigeeinrichtung in Abhängigkeit der getroffenen Auswahl aufweist, wobei in dem Eingabefeld (P) lediglich jene Eingaben ermöglicht werden, welche der getroffenen Auswahl (Schritt 33.; Schritt 34.) entsprechen, wobei die Auswerteeinrichtung ferner Mittel zum Überprüfen (Schritt 81.) aufweist, ob die in jedem Eingabefeld (P) vorgenommenen Eingaben miteinander kompatibel sind, und zwar durch Ab- bzw. Aufrufen von den Eingaben entsprechenden Datensätzen, welche in einer Datenbank bzw. einem Datenspeicher-Bereich abgelegt sind, und wobei die Auswerteeinrichtung ferner Mittel zum automatischen Generieren (Schritt 82.) einer Fehlermeldung (F) aufweist, falls die in jedem Eingabefeld (P) vorgenommenen Eingaben miteinander nicht kompatibel sind.

## Claims

1. Method of automatically producing a filter unit comprising a plurality of components or elements, the method including the following steps: Selecting (step 33) a field of application (C1) of the filter unit to be produced from among a plurality of predefined or predefinable fields of application and/or
Selecting (step 34) a configuration (C2) of the filter unit to be produced from among a plurality of predefined or predefinable configurations, Generating (steps 35-40) an input field (P) in dependence of the selection made, wherein only those inputs are enabled in the input field (P) which correspond to the selection made (step 33, step 34),
Checking (step 81) whether the inputs made in each input field (P) are mutually compatible, by means of retrieving or calling datasets that correspond to the inputs and are stored in a database or a data memory area,
wherein the step of checking (step 81) includes a step of automatically generating (step 82) an error message (F) if the inputs made in each input field (P) are not mutually compatible.

2. Method as claimed in Claim 1, wherein the generating step (steps 35-40) includes a step of determining (step 35) the number of datasets that correspond to the selection made (step 33, step 34).

3. Method as claimed in any one of the preceding claims, wherein the generating step (steps 35-40) comprises a step of generating input fields (P) that are to be sequentially processed, wherein the input fields (P) that are to be sequentially processed correspond at least partially to the respective components of the filter unit to be produced.

4. Method as claimed in Claim 3, wherein only those components are offered for selection and can correspondingly be entered in the input fields (P) to be sequentially processed which correspond to the selection made (step 33, step 34).

5. Method as claimed in any one of the preceding claims, wherein the retrieved datasets are technical characteristics of the components that were selected in the corresponding input fields (P), wherein the characteristics preferably comprise one or more dimensions of the individual components.

6. Method as claimed in any one of the preceding claims, wherein the selection (step 34) of the configuration (C2) of the filter unit to be produced is made in dependence of at least one of the following parameters: the number of filter unit chambers, the desired volume or volume areas of a housing of the filter unit, the desired filtration rate or the filtration velocity of the filter unit, a filtration module used, the inside pipe diameter of individual components, a ventilation type of the housing.

7. Method as claimed in any one of the preceding claims, which furthermore comprises a step (step 74-80, step 92) of generating a drawing on a display device or a readable medium in dependence of the selected or entered components.

8. Computer program product for automatically producing a filter unit comprising a plurality of components or elements, which can be loaded directly or indirectly into the internal memory of a computer and which comprises coding segments that can execute a method of automatically producing a filter unit comprising a plurality of components or elements in accordance with one of the preceding claims.

9. Computer system for automatically producing a filter unit comprising a plurality of components or elements, the computer system including a memory unit, an evaluation unit, an input unit and an output unit, wherein the input unit comprises means for selecting (step 33) a field of application (C1) of the filter unit to be produced from among a plurality of predefined or predefinable fields of application and/or means for selecting (step 34) a configuration (C2) of the filter unit to be produced from among a plurality of predefined or predefinable designs; wherein the evaluation unit comprises means for generating (steps 35-40) an input field (P) on the display device in dependence of the selection made,
wherein only those inputs are enabled in the input field (P) which correspond to the selection made (step 33, step 34), wherein the evaluation unit further comprises means for checking (step 81) whether the inputs made in each input field (P) are mutually compatible, by means of retrieving or calling datasets that correspond to the inputs and are stored in a database or a data memory area, and wherein the evaluation unit further comprises means for automatically generating (step 82) an error message (F) if the inputs made in each input field (P) are not mutually compatible.

## Revendications

1. Procédé pour la création automatique d'un dispositif de filtrage constitué d'une pluralité de composants ou d'éléments, lequel présente les étapes suivantes :
sélection (étape 33.) d'un domaine d'application (C1) du dispositif de filtrage à créer parmi une pluralité de domaines d'application prédéterminés ou pouvant être prédéterminés ; et/ou
sélection (étape 34.) d'un mode d'exécution (C2) du dispositif de filtrage à créer parmi une pluralité de modes d'exécution prédéterminés ou pouvant être prédéterminés ;
création (étapes 35. - 40.) d'un champ de saisie (P) en fonction de la sélection faite, sachant que, dans le champ de saisie (P), seules les saisies qui correspondent à la sélection faite (étape 33. ; étape 34.) sont rendues possibles ;
vérification (étape 81.) si les saisies effectuées dans chaque champ de saisie (P) sont compatibles entre elles, et cela par l'interrogation ou la consultation de groupes de données qui correspondent aux saisies et qui sont mémorisés dans une base de données ou dans une zone de la mémoire de données,
sachant que l'étape de la vérification (étape 81.) présente une étape de la génération automatique (étape 82.) d'un message d'erreur (F), si les saisies effectuées dans chaque champ de saisie (P) ne sont pas compatibles entre elles.

2. Procédé selon la revendication 1, dans lequel l'étape de la création (étapes 35. - 40.) présente une étape de la détermination (étape 35.) du nombre de groupes de données qui correspondent à la sélection faite (étape 33. ; étape 34.).

3. Procédé selon l'une des revendications précédentes, dans lequel l'étape de la création (étapes 35. - 40.) comporte une étape de la création de champs de saisie (P) devant être traités séquentiellement, sachant que les champs de saisie (P) devant être traités séquentiellement correspondent au moins partiellement aux composants respectifs du dispositif de filtrage à créer.

4. Procédé selon la revendication 3, dans lequel seuls les composants qui correspondent à la sélection faite (étape 33. ; étape 34.) sont proposés pour la sélection et peuvent être en correspondance entrés dans les champs de saisie (P) devant être traités séquentiellement.

5. Procédé selon l'une des revendications précédentes, dans lequel les groupes de données consultés sont des propriétés techniques des composants qui sont été sélectionnées dans les champs de saisie correspondants (P), sachant que les propriétés comportent de préférence une ou plusieurs dimensions des composants individuels.

6. Procédé selon l'une des revendications précédentes, dans lequel la sélection (étape 34.) du mode d'exécution (C2) du dispositif de filtrage à créer a lieu en fonction d'au moins un des paramètres suivants : le nombre de chambres du dispositif de filtrage, le volume souhaité ou la plage de volume souhaitée d'un carter du dispositif de filtrage, le taux de filtration souhaité ou la vitesse de filtration souhaitée du dispositif de filtrage, un module de filtration mis en place, le diamètre intérieur de tuyauterie des composants individuels, un mode de ventilation du carter.

7. Procédé selon l'une des revendications précédentes, lequel présente en outre une étape (étapes 74. - 80. ; étape 92) de la création d'un dessin sur un appareil d'affichage ou sur un support lisible, en fonction des composants sélectionnés ou saisis.

8. Produit de programme informatique pour la création automatique d'un dispositif de filtrage constitué d'une pluralité de composants ou d'éléments, lequel peut être chargé directement ou indirectement dans la mémoire interne d'un ordinateur et lequel comporte des sections de codage qui peuvent exécuter un procédé pour la création automatique d'un dispositif de filtrage constitué d'une pluralité de composants ou d'éléments, conformément à l'une des revendications précédentes.

9. Système informatique pour la création automatique d'un dispositif de filtrage constitué d'une pluralité de composants ou d'éléments, lequel comporte une unité de mémoire, une unité d'évaluation, une unité de saisie et une unité de sortie, dans lequel l'unité de saisie présente des moyens pour sélectionner (étape 33.) un domaine d'application (C1) du dispositif de filtrage à créer parmi une pluralité de domaines d'application prédéterminés ou pouvant être prédéterminés et/ou des moyens pour sélectionner (étape 34.) un mode d'exécution (C2) du dispositif de filtrage à créer parmi une pluralité de modes d'exécution prédéterminés ou pouvant être prédéterminés ; dans lequel le dispositif d'évaluation présente des moyens pour créer (étapes 35.- 40.) un champ de saisie (P) sur le dispositif d'affichage en fonction de la sélection faite, sachant que, dans le champ de saisie (P), seules les saisies qui correspondent à la sélection faite (étape 33. ; étape 34.) sont rendues possibles ; dans lequel le dispositif d'évaluation présente en outre des moyens pour vérifier (étape 81.) si les saisies effectuées dans chaque champ de saisie (P) sont compatibles entre elles, et cela par l'interrogation ou la consultation de groupes de données qui correspondent aux saisies et qui sont mémorisés dans une base de données ou dans une zone de la mémoire de données, et dans lequel le dispositif d'évaluation présente en outre des moyens pour générer automatiquement (étape 82.) un message d'erreur (F), si les saisies effectuées dans chaque champ de saisie (P) ne sont pas compatibles entre elles.
